# EUROPEAN PATENT SPECIFICATION

(11) **EP 1 946 378 B1**
(45) Date of publication and mention of the grant of the patent: **12.12.2012**
(21) Application number: 06809727.8
(22) Date of filing: 27.10.2006
(51) Int. Cl.: H01L 21/336, H01L 29/06

(54) **METHOD OF MANUFACTURING A SEMICONDUCTOR DEVICE**
VERFAHREN ZUR HERSTELLUNG EINES HALBLEITERBAUELEMENTS
PROCEDE DE FABRICATION D'UN DISPOSITIF A SEMI-CONDUCTEURS

(30) Priority: 02.11.2005 EP 05110255
(43) Date of publication of application: 23.07.2008
(73) Proprietor: NXP B.V., 5656 AG Eindhoven (NL)
(72) Inventor: LUDIKHUIZE, Adrianus, W., Redhill Surrey RH1 5HA (GB); WEIJLAND, Inesz, M., Redhill Surrey RH1 5HA (GB); STRIJKER, Joan, Wichard, Redhill Surrey RH1 5HA (GB)
(74) Representative: Williamson, Paul Lewis
(86) International application number: PCT/IB2006/053960
(87) International publication number: WO 2007/052196

(56) References cited:
- WO-A-2004/084310
- US-A1- 2004 201 061
- US-A1- 2005 127 450
- MORANCHO F ET AL: "NEW POWER LATERAL AND VERTICAL FLIMOS STRUCTURES GENERATIONS" INTERNATIONAL SEMINAR ON POWER SEMICONDUCTORS, XX, XX, 30 August 2000 (2000-08-30), pages 107-111, XP001026918

## Description

The invention relates to a method of manufacturing a semiconductor device comprising:
- a substrate of a first conductivity type having a surface,
   a) Implanting a first dopant to form a first region of a second conductivity type in the substrate,
   b) Implanting a second dopant into the first region to form a second region of the first conductivity type, the first region and the second region forming a pn junction.

In US 4,754,310 (Figs. 6, 7) a lateral HV-FET is shown having a plurality of alternating p-n-layers in the drift-region. The High Voltage FET is manufactured using a plurality of epitaxial layers of alternating conductivity type. The interleaved structure of first and second regions of alternating conductivity type forms the drift region in the high voltage transistor, carrying the high voltage which occurs across the depleted drift region. In this way multiple parallel paths contribute to the current and to a lower on-state resistance in the drift-region, whilst the Resurf principle allows for a high breakdown voltage if the charge balance is correct. A disadvantage of the method is a somewhat difficult access from the top-surface to the various layers in depth, for which in this application V-grooves are used. Another disadvantage is the less accurate control of the rather critical dose of dopant in each layer in the drift-region because of the use of epitaxy.

In US 6,509,220 a method is disclosed for making a high-voltage insulated-gate field-effect transistor with one or more conduction channels in the drift-region. In this application the conduction channels in the extended drain are formed by successive deep implantation of a dopant of a first conductivity type in a deep well or in an epitaxial layer of a second conductivity type so as to form a plurality of buried layers disposed at different vertical depths. The deep well or epitaxial layer of a second conductivity type is formed in or on a substrate of a first conductivity type. A second epitaxial layer of the second conduction type may be formed on the deep well or first epitaxial layer and the deep implant of the first conductivity type is repeated to form a second plurality of buried layers in stacked parallel relationship to the first plurality of buried layers. The stacked p-n layers in the extended drain from a drift region of the HVFET. When the HVFET is in an ON mode, a drift current flows between source and drain. The drift region is depleted if said drift region is in an OFF mode.

A disadvantage of the known method is that for the formation of the layers of the first conductivity type disposed at different vertical depths, a high energy implanter is necessary. High energy implanters in the MeV range are very expensive and they are not commonly available in a semiconductor production line. Masking of high-energy ions becomes increasingly difficult. Moreover, implantation damage due to the high energy ions may result in reliability issues.

International Patent Application Publication WO2004/084310-A discloses a silicon carbide device having a first epitaxial region with two implanted regions therein, and overlaid by a second epitaxial region.

It is an object of the present invention, inter alia, to provide a method of fabrication for the device type as mentioned in the opening paragraph that is cheaper than the prior art.

The object of the method according to the invention is achieved in that the second region of the first conductivity type is a surface layer which is formed by implanting the second dopant at the surface of the substrate. Subsequently the surface layer is covered by an epitaxial layer of the first conductivity type on the surface layer.

The invention is based on the insight that the second region of the first conductivity type is formed by a relatively low-energy implantation at the surface and followed by epitaxial growth of an epitaxial layer of the same first conductivity type on that surface layer. The combination of an implantation at the surface and epitaxial growth circumvents the use of a high-energy implantation of several MeVs. A reduction in cost per wafer is obtained. By omitting a high-energy implantation in the MeV range, the method can be applied in conventional wafer-fabs. This offers significant advantages in flexibility to manufacture semiconductor devices in different wafer-fabs all over the world.

Moreover, in the absence of a high-energy implantation to form one or more layers at different depth in a direction vertical to the substrate, the implantation damage is reduced. More reliable devices can be obtained.

Furthermore, the use of an epitaxial layer of the first conductivity type allows for easier access in depth to other layers of the first conductivity type and to the substrate.

In the prior art method of US 4,754,310, the p-n layers in the drift region are formed by epitaxial growth only. In the known method, the dopant concentration during epitaxial growth can't be very well controlled, in particular not for the relatively low dopant concentrations which are used in high voltage devices based on the RESURF (reduced surface fields) principle.

In the method according to the invention, the first epitaxial layer of the first conductivity type is implanted with a third dopant to form a third region of the second conductivity type in the first epitaxial layer, the third region forming with the second region a pn junction. Improved control of dopant concentration can be obtained by exceeding (overdoping) the (relatively low) dopant concentration of the first epitaxial layer, (e.g. p-type) by means of implantation (e.g. n-type). This method allows a tight control of dopant atoms in the p-n layers used for RESURF purposes. RESURF is obtained when the p-n layers under reverse-bias voltage are fully depleted before premature internal breakdown occurs. The depletion region is very sensitive to the dopant concentration of both the p and n parts of the layers. So in order to obtain fully-depleted p-n layers without exceeding the critical value of the electric field for breakdown, a good control of the dopant concentration is very important.

In a particular advantageous embodiment of the method suitable for RESURF the first epitaxial layer is high-ohmic. This means that during epitaxial growth a relatively low concentration of dopant atoms is incorporated. The high ohmic epitaxial layer may be used in combination with a well-controlled implantation of ions of opposite conductivity type and a subsequent optional diffusion. Because the dopant concentration in the high-ohmic epitaxial layer is only small, there are not many dopant atoms necessary to compensate for these small amounts. In this way very low dopant concentrations with a very good control in the low concentration range is possible. In particular dopant concentrations below 5e16 at/cm³ can be easily obtained with a very good control. On the other hand some dope of the first epitaxial layer is useful for device isolation and contact to body/substrate, as will be shown below.

The formation of alternating p-n layers by means of a surface implantation combined with epitaxial growth and subsequently overdoping of the epitaxial layer with a dopant of opposite conductivity type may be repeated one or more times. A plurality of stacked p-n layers may be formed on the substrate in this way. By applying these stacked p-n layers in the extended drain of a HVFET, the advantages are significant: by increasing the number of layers of the second type, the ON-resistance (Ron) is reduced.

Preferably the first conductivity type is p-type. The use of a p-type substrate in combination with a p-type epitaxial layer allows for an easy way of electrically insulating n-type transistors. Junction isolation is much easier and cheaper than deep trench isolation. Deep trench isolation is optionally applied when a p-type substrate is combined with n-type epilayers as disclosed in the prior art.

Preferably the thickness of the first and further epilayers is less than 4.5 µm. By choosing the thickness of the epilayer not too thick, only a limited temperature budget is required for diffusing dopant atoms of opposite conductivity type into the first epitaxial layer for overdoping the dopant concentration in the epilayer. The thinner the epilayer, the lower the thermal budget necessary for diffusing the dopant atoms in the epilayer, and the better the control over the dopant concentration in the overdoped epilayer. As already mentioned, a good control of the dopant concentration is very important in RESURF devices.

The growth of the first and further epitaxial layers is preferably done at a temperature below 1150 °C. The first epitaxilal layer is grown on a highly-doped surface layer of the first conductivity type. In order to limit the segregation and/or evaporation of dopant atoms from the surface layer when starting the epitaxial growth process of the first epitaxial layer, the temperature should preferably be below 1150 °C. Alternative ways to reduce the segregation of dopant atoms (in particular Boron), is to ramp up the EPI reactor, and omit all additional temperature steps usually done such as a H₂ bake or furnace anneal step.

In order to form a surface layer, the energy of the implantation of the second dopants is perferably below 350 keV.

The manufacturing method as described above can be applied advantageously in a High-Voltage Lateral MOSFET or Double-diffused MOS (LDMOS) transistor. In an LDMOS the source is surrounded by a body region, both self-aligned to the poly-silicon gate. The extended drain comprises a plurality of p-n layers disposed on top of each other. In order to have a drift current path that allows current to flow in all drift layers of the second type, it is also desirable to block by masking all other vertically disposed layers of the first conductivity type at the source and drain side. For example, leaving an opening in the second region (which is for instance p-type), allows the first region to be linked with the third region and with source and drain. A good link to the source and drain region of the LDMOS transistor is of importance for an optimal current flow through the channels, as well as to obtain a low ON resistance.

For high-voltage applications, the lateral HV-FET or HV-LDMOS transistor can have an interdigitated finger structure. A particular advantageous embodiment is obtained when over the width of the fingers a local contact between the second region (and/or higher order) of the first conductivity type and the substrate or MOS-well or body is made. This local contact allows a more rapid charge and discharge at fast switching.

In other advantageous embodiments the second region (and/or higher order) of the first conductivity type in the drift region may be continued below the source in order to locally contact the well or Body-region and substrate via the one or more epitaxial layers of the first conductivity type.

Due to body-processing after epitaxy and the need for a vertical link between the layers of the second type, a reasonable thermal budget is needed after epitaxy leading to quite some dope compensation between the p-n Resurf layers. Therefore it is desirable to use mask-diluted dope in the n-link regions at source and drain where no compensating second region of the first conductivity type is present. So the first region may comprise several areas separated from each other in lateral direction as will be explained below.

These and other aspects of the invention will be apparent from and elucidated with reference to the embodiments(s) described hereinafter.

In the drawings:
Fig. 1 shows a first embodiment of the method for making a semiconductor device according to the invention by manufacturing a first and second region using p-type epitaxy (Fig.1a). This procedure is followed by manufacturing a third region (for implementation for example in an extended-drain drift-region of a HVFET) as shown in Fig. 1b.
Fig. 2 shows a schematic cross-section of an extended drain HVFET having two drift-current paths formed by the first and third region of second conductivity type (Dual path).
Fig. 3 shows a cross-section of the HV-FET in Fig.2, wherein the first region comprises several areas in lateral direction. The second region is not present to compensate the dopant concentration of the first region.
Fig. 4 shows the simulated current flow in the drift region as a function of depth for the HV-FET of Fig.3.
Fig. 5 shows the simulated potential distribution in the HVFET of Fig.3 at breakdown.
Fig. 6 shows another embodiment of the method for making a drift-region according to the invention, here for manufacturing an extended-drain drift-region with 3 parallel paths (Triple path).
Fig. 7 shows a schematic cross-section of an extended-drain LDMOST with three drift current paths (Triple path), having 5 regions of alternating type in the substrate.
Fig. 8 shows a cross-section of the HV-LDMOS in Fig.7, now having the preferred mask-dilution of the first and third region where the second region is not present for compensation.
Fig. 9 shows the simulated corresponding dopant profile of the device in Fig. 8 in the vertical direction.
Fig. 10 shows the simulated current flow in the drift region as a function of depth for the LD-MOSFET of Fig. 8.
Fig. 11 shows the simulated potential distribution in the LDMOST of Fig. 8 at breakdown.
Fig. 12 shows a cross-section of the triple-path LDMOST at a location where the source and the drain link with the various n-type regions (Fig.12a). Fig. 12b shows a cross-section of the same triple-path LDMOS at a location with contact between the alternating layers of the first conductivity type (RP and RP2) to the substrate and body via the first and the second epilayer.

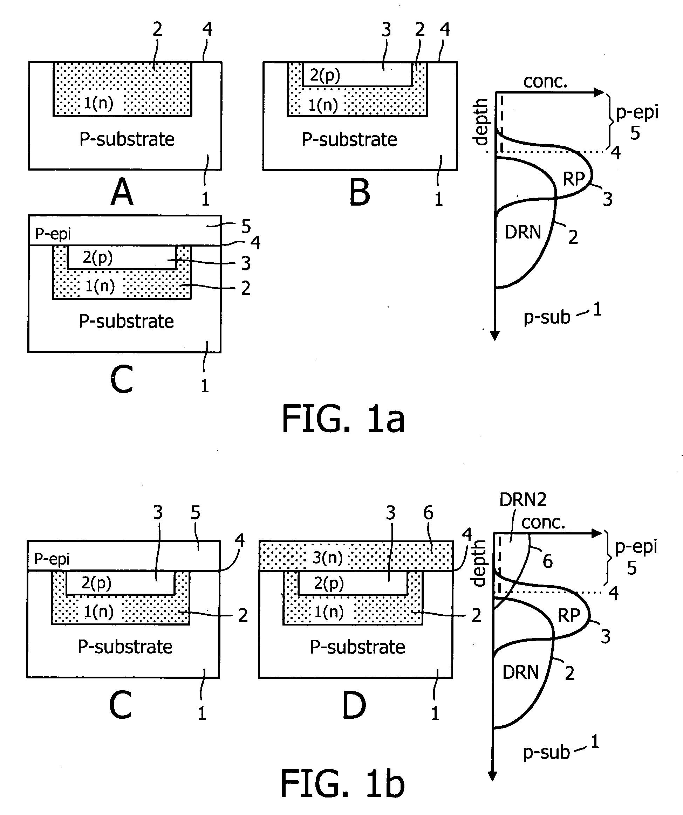

Fig. 1 shows a first advantageous embodiment of the method according to the invention. A p-type Si substrate 1 is with mask implanted with n-type dopant atoms to form a first region 2. In this example P atoms are used with an implantation-energy of 100 keV and a dose of about 6e12 at/cm². For RESURF the implantation dose is preferably in a range between 1e12 and 1e13 at/cm². A high temperature diffusion step during 540 min. at 1150 °C drives the n-type dopant atoms deeper in the p-type substrate, thereby forming a deep n-type region 2 (here labeled Deep Resurf n, DRN see Fig. 1A).

A second region 3 is formed by implanting with mask a p-type dopant such as Boron or Indium, the surface 4 of the substrate 1 (Fig. 1B). Here Boron is implanted at an energy of 100-180 keV and a dose of about 6e12 at/cm². For Resurf the implantation dose is preferably in a range between 1e12 and 1e13 at/cm². Thus a p-type layer at the surface 4 is formed. Optionally the Boron dopant atoms can be diffused, or activated during epitaxial growth in the next step. The dopant profile of the p-type second region 3 is indicated here as Resurf p, RP.

On the surface 4 a p-type Si epitaxial layer 5 having a thickness of 2-4 µm is grown epitaxially at 1150 °C (Fig. 1C).

Subsequently this layer is implanted with P-atoms of 100-300keV at a dose of about 1.4e12 at/cm² and optionally diffused to provide a third region 6 (labeled here DRN2) with n-type dopant (Fig. 1D). After complete processing the netto doses in the DRN and RP layers are each about 2e12 at/cm², in the DRN2 layer about 1e12 at/cm². The sheet resistance of the third region (DRN2) after processing is then about 6 kOhm/square. Preferably the implantation dose for the third region is between 0.5e12 and 1e13 cm⁻².

The method according to the invention is not limited to Si substrates. Any semiconductor substrate can be used, such as SiC, Ge, SiGe, InP, GaAs, GaN etc. As long as pn junctions can be formed in a semiconductor substrate, the principle of RESURF can be applied.

The formation of the deep Resurf N (DRN) and Resurf P layer (RP) with on top a p-type epitaxial layer with subsequent n-type implantation (for DRN2) can be advantageously used in the manufacture of many semiconductor devices, such as a bipolar transistor, IGBT, Lateral MOSFETs and DMOSFETs.

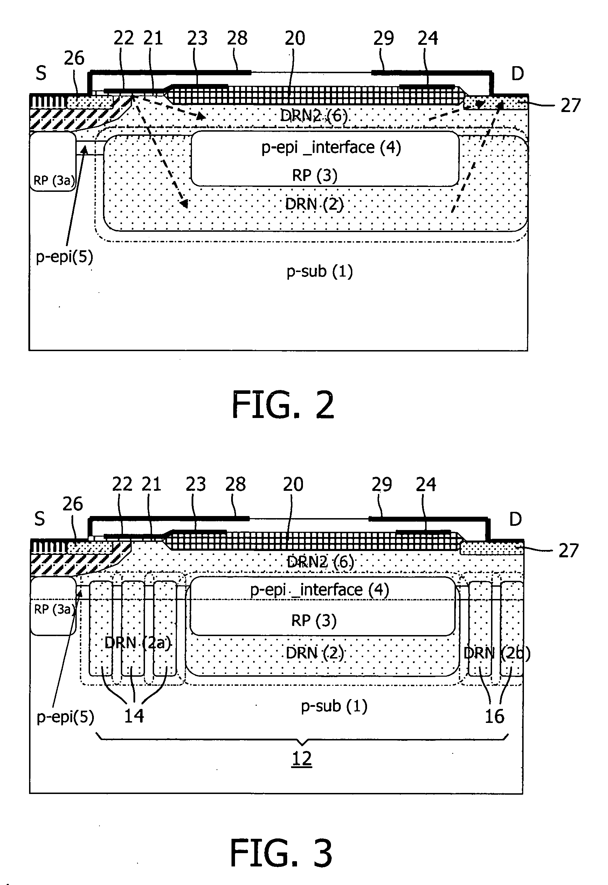

Fig. 2 shows a schematic cross-section of a particular advantageous example of a Lateral Double-diffused MOSFET having an extended drain on a p-substrate 1 comprising two n-type drift current paths 2 (DRN) and 6 (DRN2) with intermediate p-layer 3 (RP) between the source (S) and the drain (D).

After formation of the 3 layers (1(n), 2(p), 3(n)) as indicated in Fig.1b, the Lateral HV-MOSFET process is continued. Forming a local field-oxide 20, preferably with Locos of about 1µm thick, forming a gate-oxide 21 and an n+-doped poly-silicon gate 22 with field-plate at the source-side 23 and optionally also at the drain-side 2). Forming by implantation, preferably self-aligned to the poly-silicon gate, and by subsequent diffusion a p-type body and lateral channel-region (preferably of the DMOS type) 25, followed by implantation of an n+ source 26, preferably self-aligned to the poly-silicon gate, and an n+ drain 27, preferably self-aligned to the Locos field-oxide. Forming by deposition an intermetallic dielectric layer, preferable by TEOS or LTO oxide of about 1µm thick, followed by opening contact-windows and deposition and etching of metallization for source with field-plate 28, for gate (not shown) and for drain with field-plate 29. This is covered by a dielectric scratch protection also enhancing the HV stabilization, in which openings for bond-pads are made.

In the ON-state, electrons flow from the source and MOS-channel to the drain through the two n-channel drift regions (Dual path). The total ON-state resistance (Ron) of the HV MOSFET now consists of the two resistances in parallel; this significantly lowers the ON resistance of the device. HV DMOS transistors are used as switches in HV power supplies. The switches allow power conversion at 100-500 kHz. For those power switches the ON-resistance (Ron) and Breakdown voltage (BVds) value are very important parameters.

The n-links at the source and drain side are preferably designed with reduced dopant concentration obtained by mask-patterning, as is indicated in Fig.3 (DRN-2a, DRN-2b). The separation of the first region 2 in several areas 12 is desirable since the dope of both n-regions without a compensating P-region is rather high.

The first epitaxial layer 5 initially was p-type after epitaxial growth. After diffusion of the P atoms, a third region as an n-well 6 (DRN2) is formed. This n-well extends between the second region 3 and the upper surface of the first epitaxial layer 5. The n-well forms with the second region (RP) a pn junction. The n-type P atoms of the first region (DRN) compensate for a certain (large) amount the p-type concentration of the second region (RP). In this example about 65 % of the dopant concentration of the DRN and RP layers is compensated. The dopant concentration in the p-n layers is critical when used for RESURF. So the implantation dose of both the B as well as the P is critical in combination with the thermal budget.

The use of epitaxy of the first conductivity type is advantageous for a proper device isolation under the source to the body region. Notice that the n-regions are relatively deep and the p-regions are relatively shallow. With an epilayer of the second conductivity type together with a shallow body-diffusion as disclosed in the prior art of US 6,509,220 , the shallow RP layer would be more difficult. The same applies if more alternating layers are used (see below).

The HV LDMOST of Fig. 2 with an extended drain comprising a first region N layer (DRN), a second region P layer (RP) with on top an n-well (DRN2) can be manufactured using the method as explained here above.

Fig. 3 shows a cross-section of the device of Fig.2 having reduced doping in the first region on locations without a second region 14, close to the source and preferably also at the drain 16. A dashed line indicates the out-diffusion edge. So the first region 2 is split up in several areas 12 in lateral direction.

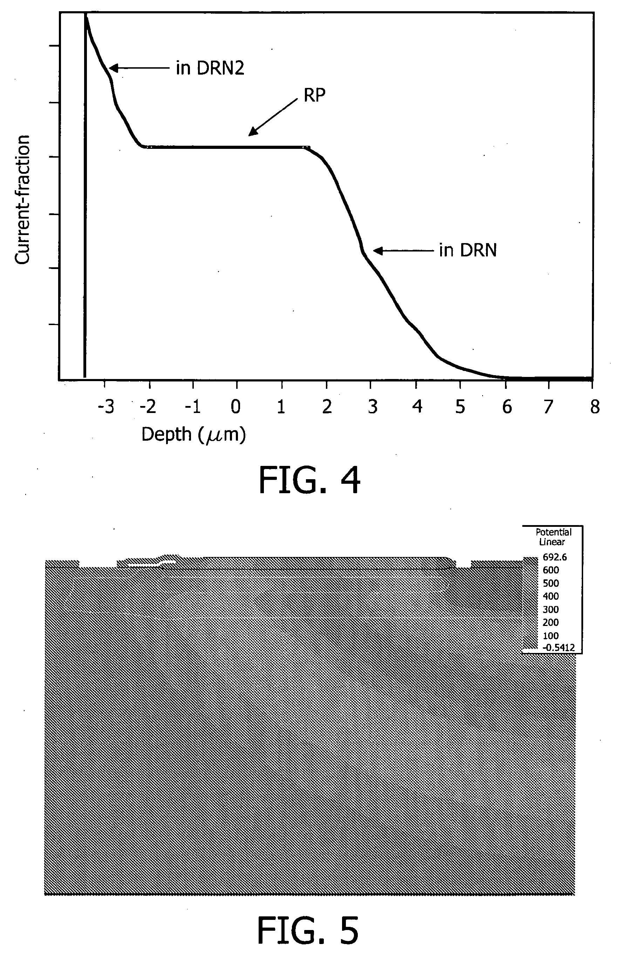

Fig. 4 indicates the simulated current flow as a function of depth through the LDMOS transistor as shown in Fig.3. The simulated current flow-lines are calculated at Vds= 0.1 V.

The current-flow through the LDMOS depends on ratio of the sheet resistances of the various layers. The calculated sheet resistance for the NW2 was 6.20 kOhm/sq and for the BN layer was 3.37 kOhm/sq. As a consequence 35% of the current flows through the NW2 and 65% through the BN layer. For a Locos length (or drift length) of 55 µm, a typical value of Ron*A = 9 Ohm.mm² can be obtained, where A is the active area of the device.

In Fig. 5 is shown that the simulated breakdown voltage BVds is 692 V for a drift length of 55 µm. The simulated LDMOS is therefore very suitable for high voltage applications. By increasing the drift length (e.g. to 65 µm), the breakdown voltage is increased. The penalty is of course the increase in On-resistance, resulting in Ron *A= 12.4 Ohm.mm².

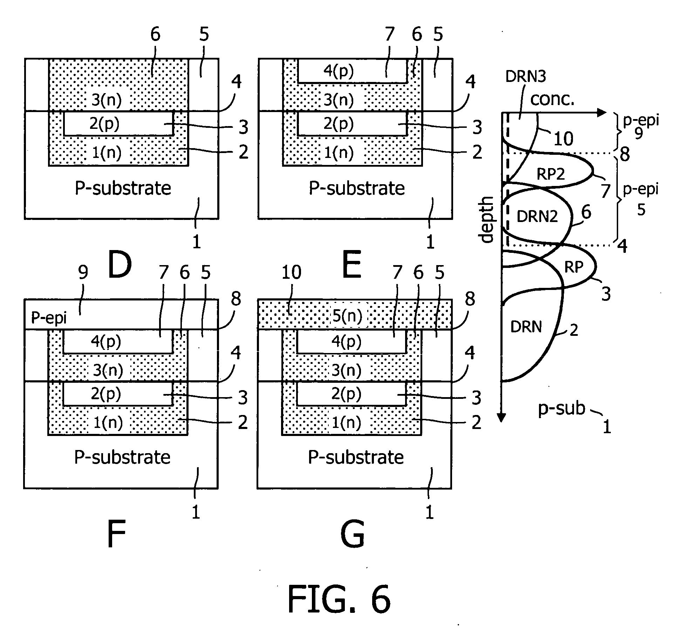

Fig.6 shows a second advantageous embodiment of a drift-region using the method according to the invention, now for manufacturing an extended-drain drift-region with 3 parallel paths. After applying with masks a first n-type region 2 (DRN) and second p-type region 3 (RP), followed on interface 4 by a now slightly thicker p-type epitaxy 5 and implantation, this time with mask, of a third n-type region 6 (Fig. 6D, DRN2) with some more energy and diffusion, a fourth region 7 of p-type is implanted with mask (Fig. 6E, RP2). After this on interface 8 a second p-type epitaxial layer 9 is grown (Fig. 6F) which is implanted with a blanket n-type layer (10) for obtaining a fifth region of n-type (Fig.6G, DRN3).

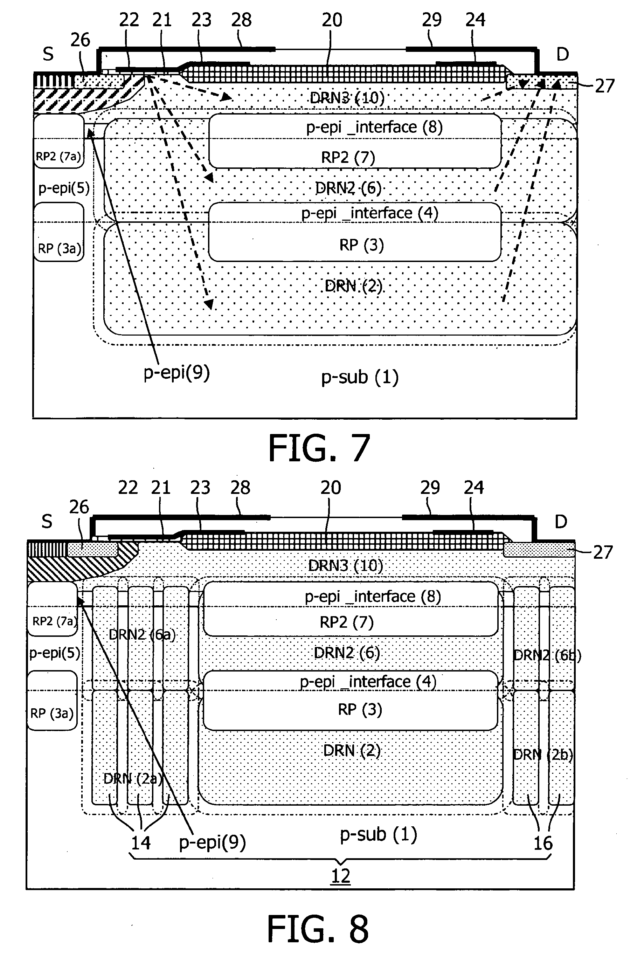

The schematic drawing of the LDMOS transistor in Fig. 7 shows how the method according to the invention can be applied in a triple-path LDMOS device. Again at the location of a vertical link between the n-layers at source and drain, without compensating p-layers, some dilution of the n-dose by mask-pattern is desirable, as is indicated (DRN-2a, DRNN-2b; DRN2-6a, DRN2-6b). The use of p-type epitaxy now allows for a more easy connection between RP-3a , RP2-7a and body/substrate for appropriate device isolation and grounding of the alternating p-type layers.

In the ON-state there are now three n-type drift current paths (DRN, DRN2 and DRN3). The three n-type regions are separated by two p-type regions (RP and RP2).

Fig.8 shows a cross-section of the device of Fig.7 having reduced doping in the first region on locations without a second region, close to the source and preferably also at the drain. A dashed line indicates the out-diffusion edge.

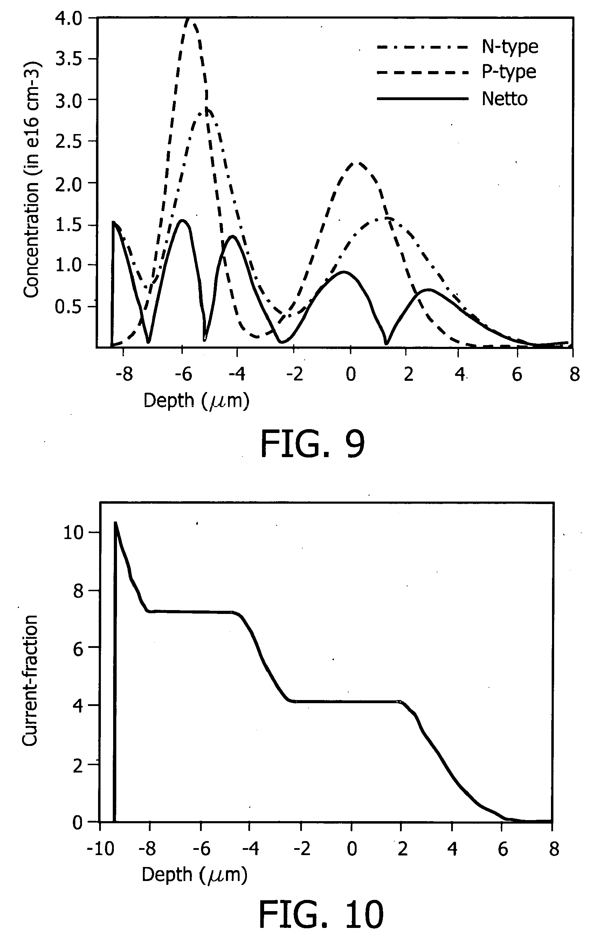

The simulated dopant concentration as a function of depth in the triple-path LDMOS of Fig.8 is shown in Fig. 9. The dotted line shows the active Phosphorus concentration (n-type) and the dashed line indicates the active Boron concentration (p-type). The drawn line refers to the net dopant concentration as a function of depth.

The simulated current flow in the triple path LDMOS as a function of depth is shown in Fig. 10. A very nice current distribution is shown at Vds= 0.1V. The specific sheet-resistances of the n-type layers is : NW2=6k/sq, NW=3.5k/sq and BN=3.62k/sq. The current flowing through these n-type layers is in accordance with the values of the sheet resistances. The percentage of current flowing through the NW2 is 20%,the NW 40% and BN 40%. The On-resistance for the triple path LDMOST was extracted at Vds=0.1V, Vgs=14V to be Ron*A=5.7 Ohm.mm².

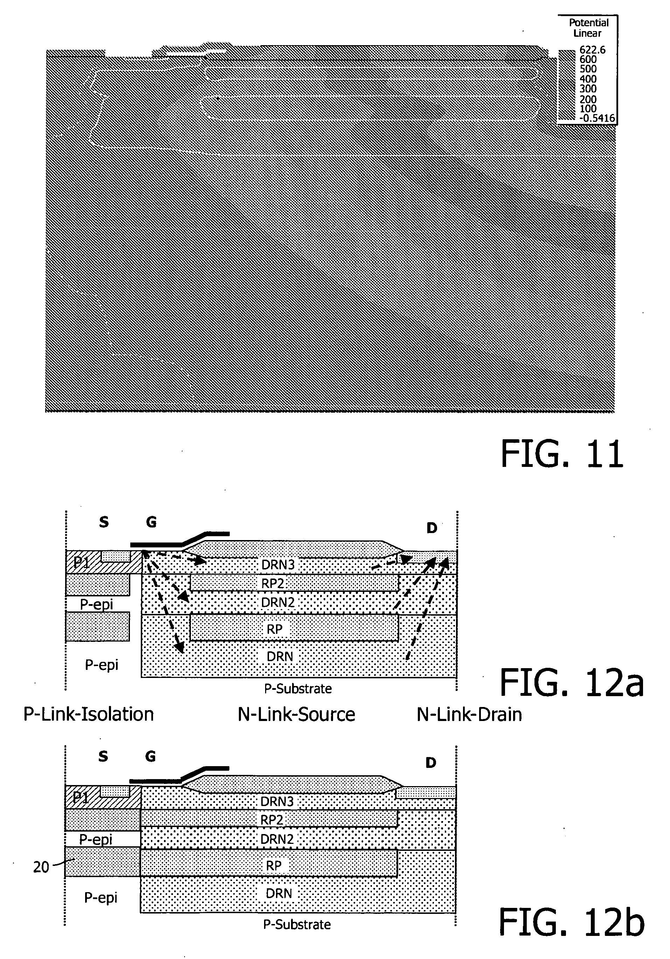

Fig. 11 shows the simulation of the corresponding breakdown voltage. For a drift-length of 55 µm, the calculated breakdown voltage is 652V. A further increase in breakdown voltage is possible, by taking care that the electric field lines in BN do not shift too fast to the drain. The BN-implantation dose, which was here 6.5e12 at/cm² should therefore be slightly adapted for obtaining a breakdown voltage BVds of around 720 V.

Fig. 12 shows an embodiment of the triple-path LDMOST which is arranged for fast switching. The triple path LDMOST (Fig.12a) has a finger structure. The "N-link-at Source" comprises diluted n-regions 14 in the DRN and DRN2 layers, as is shown in Fig.8.

Over the width of the fingers locally the RP/RP2 are continued through the "N-Link-at-Source" (Fig 12b). So a local contact between the RP/RP2 layers in the drift region and the Body/substrate is made. The local contact enables a more rapid charge and discharge at fast switching. The local contact reduces W-effective by 1-2% only.

Further improved embodiments of the LDMOST can be obtained by including one or more of the measures indicated below:
At the Source fingertips ('heads') the n-layers may be somewhat withdrawn and/or mask-diluted and the p-layers remain more present, in order to smooth the dope-transition and the effect of the junction curvature. These Source fingertips are not active (no Source) and the S-to-D distance is larger.

Also at the Drain fingertips ('heads') the S-to-D distance may be larger and the field-plates stretched. The drain fingertips have no Source around, in order the limit the concentration of current at this fingertip.

The method according to the invention can be combined with the manufacturing of other transistors on an integrated circuit. The LDMOSTs as described above can be combined with a HV-NJFET, with CMOS circuitry and/or with a HV-PMOS. Small modifications to the LDMOST might be desirable.

For example, at the Drain fingertip a HV-NJFET can be included, which is particularly useful for start-up current to a low voltage (LV) control section or chip.

It is also possible to integrate CMOS circuitry. In this case the body region surrounding the source might be replaced by a P-well implanted and diffused before the Polygate is applied, which P-well also can be used for LV NMOS and CMOS.

Also an integrated HV-PMOS device is possible. This might be useful for example for sensing an isolated output (secondary) at the non-isolated primary (switching) side.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "to comprise" and its conjugations does not exclude the presence of elements or steps other than those stated in a claim. The article "a" or "an" preceding an element does not exclude the presence of a plurality of such elements. The mere fact that certain measures are recited in mutually different dependent claims does not indicate that a combination of these measures cannot be used to advantage.

## Claims

1. A method of manufacturing a semiconductor device comprising:
- a substrate of a first conductivity type (1) having a surface (4),
a) Implanting a first dopant to form a first region (2) of a second conductivity type in the substrate,
b) Implanting a second dopant into the first region to form a second region (3) of the first conductivity type, the first region (2) and the second region (3) forming a pn junction, which second region (3) is a surface layer which is formed by implanting the second dopant at the surface (4) of the substrate, and subsequently the surface layer is covered by
c) forming a first epitaxial layer (5) of the first conductivity type on the surface layer(3), **characterized in that** d) the first epitaxial layer is implanted with a third dopant to form a third region (6) of the second conductivity type in the first epitaxial layer (5), the third region extending through the first epitaxial layer (5) after diffusion of the third dopant, so that the third region forms with the second region (3) a pn junction.

2. A method as claimed in claim 1, **characterized in that** e) a fourth dopant is implanted into the third region to form a fourth region (7) of the first conductivity type, the third region (6) and the fourth region (7) forming a pn junction.

3. A method as claimed in claims 1 or 2, **characterized in that** a plurality of stacked pn junctions is formed on the substrate by repeating the steps c), d) and e) another n times, n being an integer, so that the first epitaxial layer is updated with n, the third region is updated with n+1, and the fourth region is updated with n+2.

4. A method as claimed in any of the proceeding claims, **characterized in that** the first conductivity type is p-type and the second conductivity is n-type.

5. A method as claimed in claims 1 or 3, **characterized in that** the thickness of the epitaxial layer is less than 4.5 µm.

6. A method as claimed in claims 1, 3 or 5, **characterized in that** the epitaxial layer is grown at a temperature below 1150 °C.

7. A method as claimed in claim 1, **characterized in that** the energy of the implantation of the dopants is below 350 keV.

8. A method as claimed in any of the proceeding claims, wherein the semiconductor device is a FET and a source region (S) is formed of the second conductivity type, a drain region (D) is formed of the second conductivity type, and a mask is used during implantation of the first and second dopants to form the first (2) and second regions (3), the first and second regions being positioned in between the source region and drain region, forming an extended drain region.

9. A method as claimed in claim 8, wherein the first region (2) comprises several areas (12) separated from each other in lateral direction.

10. A method as claimed in claim 8 or 9, wherein the semiconductor device is a High Voltage FET and a body-region (9) of the first conductivity type is formed around the source region, the body-region (9) being connected to the substrate (1) via a local connection (20) to the second region (2) of the first conductivity type.

## Patentansprüche

1. Verfahren zum Herstellen einer Halbleitervorrichtung aufweisend:
- ein Substrat eines ersten Leitfähigkeitstyps (1), welches eine Oberfläche hat,
a) Implantieren eines ersten Dotierstoffs, um einen ersten Bereich (2) eines zweiten Leitfähigkeitstyps in dem Substrat zu bilden,
b) Implantieren eines zweiten Dotierstoffs in den ersten Bereich hinein, um einen zweiten Bereich (3) des ersten Leitfähigkeitstyps zu bilden, wobei der erste Bereich (2) und zweite Bereich (3) einen pn-Übergang bilden, welcher zweite Bereich (3) eine Oberflächenschicht ist, welche mittels Implantierens des zweiten Dotierstoffs an der Oberfläche (4) des Substrates gebildet wird, und wobei anschließend die Oberflächenschicht bedeckt wird mittels
c) Bilden einer ersten epitaktischen Schicht (5) des ersten Leitfähigkeitstyps auf der Oberflächenschicht (3), **dadurch gekennzeichnet, dass**
d) die erste epitaktische Schicht mit einem dritten Dotierstoff implantiert wird, um einen dritten Bereich (6) des zweiten Leitfähigkeitstyps in der ersten epitaktischen Schicht (5) zu bilden, wobei sich der dritte Bereich durch die erste epitaktische Schicht (5) hindurch nach Diffusion des dritten Dotierstoffs erstreckt, sodass der dritte Bereich mit dem zweiten Bereich (3) einen pn-Übergang bildet.

2. Verfahren gemäß Anspruch 1, **dadurch gekennzeichnet, dass**
e) ein vierter Dotierstoff in den dritten Bereich hinein implantiert wird, um einen vierten Bereich (7) des ersten Leitfähigkeitstyps zu bilden, wobei der dritte Bereich (6) und der vierte Bereich (7) einen pn-Übergang bilden.

3. Verfahren gemäß den Ansprüchen 1 oder 2, **dadurch gekennzeichnet, dass** eine Mehrzahl von gestapelten pn-Übergängen auf dem Substrat mittels weiterem n-maligen Wiederholens der Schritte c), d) und e) gebildet wird, wobei n eine ganze Zahl ist, sodass die erste epitaktische Schicht mit n aktualisiert wird, der dritte Bereich mit n+1 aktualisiert wird und der vierte Bereich mit n+2 aktualisiert wird.

4. Verfahren gemäß irgendeinem der vorhergehenden Ansprüche, **dadurch gekennzeichnet, dass** der erste Leitfähigkeitstyp ein p-Typ ist und die zweite Leitfähigkeit ein n-Typ ist.

5. Verfahren gemäß den Ansprüchen 1 oder 3, **dadurch gekennzeichnet, dass** die Dicke der epitaktischen Schicht kleiner als 4,5 µm ist.

6. Verfahren gemäß den Ansprüchen 1, 3 oder 5, **dadurch gekennzeichnet, dass** die epitaktische Schicht bei einer Temperatur unter 1150 °C gewachsen wird.

7. Verfahren gemäß Anspruch 1, **dadurch gekennzeichnet, dass** die Energie der Implantation der Dotierstoffe unter 350 keV ist.

8. Verfahren gemäß irgendeinem der vorhergehenden Ansprüche, wobei die Halbleitervorrichtung ein FET ist und ein Source-Bereich (S) des zweiten Leitfähigkeitstyps gebildet wird, ein Drain-Bereich (D) des zweiten Leitfähigkeitstyps gebildet wird und eine Maske während des Implantierens der ersten und zweiten Dotierstoffe verwendet wird, um die ersten (2) und zweiten Bereiche (3) zu bilden, wobei sich die ersten und zweiten Bereiche zwischen dem Source-Bereich und dem Drain-Bereich befinden, welche einen ausgeweiteten Drain-Bereich bilden.

9. Verfahren gemäß Anspruch 8, wobei der erste Bereich (2) mehrere Bereiche (12) aufweist, welche von einander in lateraler Richtung getrennt sind.

10. Verfahren gemäß Anspruch 8 oder 9, wobei die Halbleitervorrichtung ein Hochspannungs-FET ist und ein Körper-Bereich (9) des ersten Leitfähigkeitstyps um den Source-Bereich herum gebildet wird, wobei der Körper-Bereich (9) mit dem Substrat (1) über eine lokale Verbindung (20) mit dem zweiten Bereich (2) des ersten Leitfähigkeitstyps verbunden ist.

## Revendications

1. Procédé de fabrication d'un dispositif à semi-conducteurs comprenant :
- un substrat d'un premier type de conductivité (1) ayant une surface (4),
a) l'implantation d'un premier dopant pour former une première région (2) d'un deuxième type de conductivité dans le substrat,
b) l'implantation d'un deuxième dopant dans la première région pour former une deuxième région (3) du premier type de conductivité, la première région (2) et la deuxième région (3) formant une jonction pn, laquelle deuxième région (3) est une couche de surface qui est formée par implantation du deuxième dopant sur la surface (4) du substrat et dans lequel ensuite la couche de surface est recouverte par
c) la formation d'une première couche épitaxiale (5) du premier type de conductivité sur la couche de surface (3), **caractérisé par le fait que** d) la première couche épitaxiale est implantée à l'aide d'un troisième dopant pour former une troisième région (6) du deuxième type e conductivité dans la première couche épitaxiale (5), la troisième région s'étendant à travers la première couche épitaxiale (5) après diffusion du troisième dopant, de telle sorte que la troisième région forme avec la deuxième région (3) une jonction pn.

2. Procédé selon la revendication 1, **caractérisé par le fait que** e) un quatrième dopant est implanté dans la troisième région pour former une quatrième région (7) du premier type de conductivité, la troisième région (6) et la quatrième région (7) formant une jonction pn.

3. Procédé selon les revendications 1 ou 2, **caractérisé par le fait qu'**une pluralité de jonctions pn empilées est formée sur le substrat par la répétition des étapes c), d) et e) n autres fois, n étant un entier, de telle sorte que la première couche épitaxiale est remplacée par n, la troisième région est remplacée par n+1 et la quatrième région par n+2.

4. Procédé selon l'une quelconque des revendications précédentes, **caractérisé par le fait que** le premier type de conductivité est le type p et que le deuxième type de conductivité est le type n.

5. Procédé selon les revendications 1 ou 3, **caractérisé par le fait que** l'épaisseur de la couche épitaxiale est inférieure à 4,5 µm.

6. Procédé selon les revendications 1, 3 ou 5, **caractérisé par le fait que** la croissance de la couche épitaxiale est effectuée à une température inférieure à 1150°C.

7. Procédé selon la revendication 1, **caractérisé par le fait que** l'énergie d'implantation des dopants est inférieure à 350 keV.

8. Procédé selon l'une quelconque des revendications précédentes, dans lequel le dispositif à semi-conducteurs est un FET et dans lequel une région de source (S) est formée du deuxième type de conductivité, une région de drain (D) est formée du deuxième type de conductivité, et dans lequel un masque est utilisé au cours de l'implantation du premier et du deuxième dopant pour former la première (2) et la deuxième (3) région, la première et la deuxième région étant positionnées entre la région de source et la région de drain, formant une région de drain étendue.

9. Procédé selon la revendication 8, dans lequel la première région (2) comprend plusieurs zones (12) séparées les unes des autres dans une direction latérale.

10. Procédé selon les revendications 8 ou 9, dans lequel le dispositif à semi-conducteurs est un FET haute tension et dans lequel une région de corps (9) du premier type de conductivité est formée autour de la région de source, la région de corps (9) étant raccordée au substrat (1) par l'intermédiaire d'une connexion locale (20) à la deuxième région (2) du premier type de conductivité.
